# EUROPEAN PATENT APPLICATION

(11) **EP 4 123 380 A1**
(43) Date of publication of application: **25.01.2023**
(21) Application number: 21187258.5
(22) Date of filing: 22.07.2021
(51) Int. Cl.: G03F 7/20, G02B 7/182, G02B 26/08

(54) **A DEFORMABLE MIRROR SYSTEM**

(71) Applicant: ASML Netherlands B.V., 5500 AH Veldhoven (NL)
(72) Inventor: VAN DE VEN, Bastiaan, Lambertus, Wilhelmus, Marinus, 5500 AH Veldhoven (NL); LEVASIER, Leon, Martin, 5500 AH Veldhoven (NL)
(74) Representative: ASML Netherlands B.V.

(57) **Abstract**

A deformable mirror system (300, 400, 500), comprising a monolithic support structure (310, 410, 510), comprising a first side (311) configured to receive a mirror (350, 450, 550); and a second side (312) configured to receive a plurality of actuators (460, 560) such that the actuators are positioned to enable selective deformation of a reflective surface (351, 451, 551) of the mirror.

## Description

### FIELD

The present invention relates to a deformable mirror system, comprising a monolithic support structure, which may be used in a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Lithographic apparatus often make use of one or more mirrors to focus the EUV radiation. The shape or position of the one or more mirrors may be adjusted to correct for any changes that arise in the apparatus that otherwise could cause, for example, aberrations in the resulting EUV beams and would therefore be detrimental to the performance of the apparatus. Such changes could be caused by either long-term drift of a component or shorter-term thermal changes, for example, heating of particular regions of a mirror. Adjustable or deformable mirrors can also be used in lithographic apparatus to correct for distortions in the system.

A deformable mirror may include one or more actuators, e.g. piezoelectric or electrostatic actuators, that are fixed to a mirror with a direction of actuation approximately parallel to the surface of the reflective mirror surface.

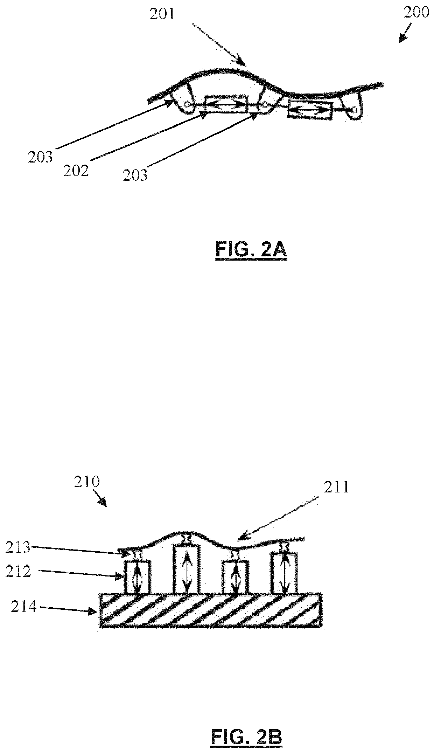

When activated, the one or more actuators extend or contract, causing the reflective mirror surface to deform. As the one or more actuators extend or contract in a direction that is approximately parallel to the reflective mirror surface, it is referred to as surface parallel actuation. Figure 2A depicts surface parallel actuation.

It is an object of the present invention to provide improved mirror supports and methods of construction, particularly, but not exclusively, for mirrors used in EUV lithography.

### SUMMARY

In an example described herein there is deformable mirror system, comprising a monolithic support structure, comprising: a first side configured to receive a mirror; and a second side configured to receive a plurality of actuators such that the actuators are positioned to enable selective deformation of a reflective surface of the mirror. Advantageously, the deformable mirror system provides a mirror with stiffness and mechanical stability across the entirety of the mirror while still allowing local deformations. As set out above, the ability to deform a mirror may be used to impart desired characteristics to, or address the problem of aberrations in, a wave front reflected by the mirror.

The support structure may comprise a plurality of cavities which extend through the second side, each one of the plurality of cavities configured to receive at least one of the plurality of actuators. Beneficially, the plurality of cavities provide positions for the fixation of a plurality of actuators to allow deformation of the mirror.

The plurality of cavities may be arranged to form a regular 2-D lattice structure across the second side of the structure. The regular arrangement of the cavities help ensure that consistent actuation forces are able to achieve similar deformations across the mirror.

The first side may comprise a plurality of pillars, wherein each one of the plurality of pillars is configured to support the mirror. The pillars advantageously provide a gap between a supported mirror and the bulk of the support structure, which may provide mechanical decoupling of the mirror from the support structure. The gap may provide a thermal break between the mirror and the support structure. Additionally, by providing a gap between the mirror and the support structure, the mirror has additional space in which to deform, thereby making for easier deformation and providing a greater amount of possible deformation.

The plurality of pillars may be arranged to form regular 2-D lattice structure across the first side. The regular arrangement of the pillars may ensure that the mirror has consistent support across its extent, and that consistent actuation forces achieve similar deformations across its extent.

Each one of the plurality of pillars may be arranged co-axially with at least a portion of each one of the plurality of cavities. Beneficially, by providing a location for an actuator underneath each contact point between the support structure and the mirror, the deformation of the mirror may be easier to control.

The deformable mirror system may comprise the mirror, the mirror comprising a plate having a reflective mirror surface, and the plate may be fixed to the first side of the support. The reflective mirror surface may be provided by a multi-layer coating as is known to the person skilled in the art. The plurality of coatings may provide a desired optical quality of the reflective mirror surface, for example, transmittance or reflectance.

The deformable mirror system may comprise the plurality of actuators.

One or more of the plurality of actuators may be configured to apply compression or tension forces to an underside of the mirror.

A majority of the compression or tension forces from the plurality of actuators may be applied in a direction generally perpendicular to the reflective mirror surface of the mirror. Advantageously, the deformable mirror system may therefore make use of surface normal actuation reducing the effects of cross-talk that arise when using surface parallel actuation. At rest, without the application of any compression or tension forces, the first side may be substantially flat. Alternatively, it may be substantially convex, concave or another shape.

Each one of the plurality of actuators may be fixed to the deformable mirror support at a first point and a second point. The first point may be at a distal end of the cavity (closer to the second side) and the second point closer to the proximal end of the cavity (i.e. a point which is closer to the first side compared to the first point). Beneficially, by fixing each one of the plurality of actuators in this way allows the application of both compression and tension forces. Alternatively, each one of the plurality of actuators may be fixed to the monolithic structure at one point or multiple points. Beneficially, this may allow for more straightforward construction of the deformable mirror system while still providing for application of compression forces to the mirror.

Each one of the plurality of actuators may be a pneumatic, hydrostatic, Lorentz, reluctance or thermal mechanical actuator. Different types of actuators may provide different benefits. For example, pneumatic and hydrostatics actuators may be operated in a temperature insensitive manner.

A lithographic apparatus (LA) may comprise one or more deformable mirror systems.

The lithographic apparatus (LA) may be an EUV lithographic apparatus. Advantageously, a lithographic apparatus comprising two or more of the deformable mirror systems, the problem of 3rd order distortions can be corrected.

In another example described herein there is a method of deforming the deformable mirror support of the first example.

In another example described herein there is a method of constructing the deformable mirror support of the first example.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2A depicts a deformable mirror deformable by surface parallel actuation;
- Figure 2B depicts a deformable mirror deformable by surface normal actuation;
- Figure 3A depicts a cross-sectional view of a deformable mirror system;
- Figure 3B depicts a top-down view of the deformable mirror system of Figure 3A;
- Figure 3C depicts an enlarged cross-sectional view of the deformable mirror system of Figure 3A;
- Figure 4 depicts a deformable mirror system comprising a plurality of pneumatic or hydrostatic actuators; and
- Figure 5 depicts a deformable mirror system comprising a plurality of Lorentz actuators.

### DETAILED DESCRIPTION

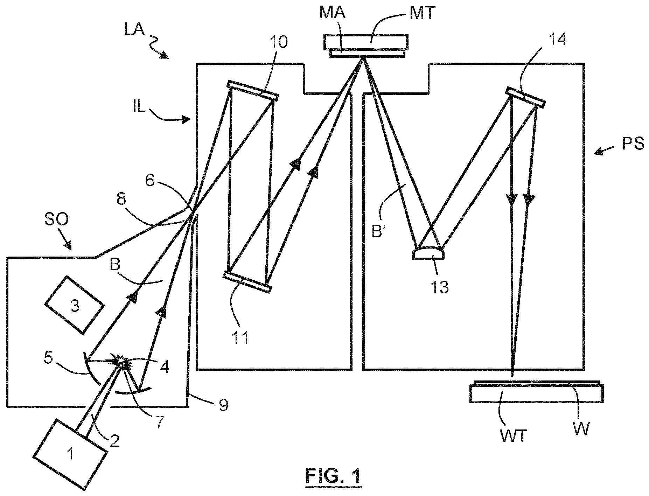

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The facetted field mirror device 10 or the facetted pupil mirror device 11 may be deformable and include or make use of a deformable mirror system. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11. The other mirrors may be deformable and include or make use of a deformable mirror system.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13, 14 which are configured to project the patterned EUV radiation beam B' onto the substrate W held by the substrate table WT. One or more of the plurality of mirrors 13, 14 may be deformable and include or make use of a deformable mirror system. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during deexcitation and recombination of electrons with ions of the plasma.

The EUV radiation from the plasma is collected and focused by a collector 5. The collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below. The collector may be deformable and include or make use of a deformable mirror system.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The directing mirrors, beam expanders or other optics may be deformable and include or make use of the deformable mirror system. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

Optical surface deformation may occur in mirrors, for example mirrors in the projection system PS of the EUV lithographic apparatus LA. It will be appreciated that, although the following description generally relates to a deformable mirror system in the EUV lithographic apparatus LA, the apparatus and methods described are also applicable to other components in other lithographic apparatus, such as a DUV lithographic apparatus. Similarly, while the following description is concerned with lithographic apparatus, it will be appreciated that the deformable mirror systems described herein may be used in other applications for which deformable mirrors are desired.

In the lithographic apparatus LA, incoming electro-magnetic (EM) waves (i.e. EUV radiation) interact with mirror(s) with some of the radiation being reflected and some absorbed. The absorbed radiation is dissipated within the mirror which leads to mirror heating. Heat is conducted within the mirror and thus the mirror temperature changes over time. The temperature changes cause the mirror to deform which leads to wavefront aberrations. These wavefront aberrations may need to be corrected in the lithographic apparatus LA, for example to improve the imaging performance of the lithographic apparatus LA.

With increasing EUV radiation source powers, mirror heating becomes an increasing problem in EUV lithographic apparatus LA. Furthermore, some extreme illumination profiles may lead to a problematic amount of heating in a portion of the mirror, despite other areas of the mirror remaining at an acceptable temperature. In such instances the mirrors of the projection optics (e.g. projection system PS) may heat up too much, deform and cause aberrations that cannot be sufficiently corrected.

As explained in the background section, it is known to provide deformable mirrors with surface parallel actuation, as depicted in figure 2A. Figure 2A depicts a mirror 200 and how a reflective surface 201 can be deformed by an actuator 202 which is fixed to the backside of the mirror at points 203 and actuates in a direction parallel to the mirror surface 201.

However, surface parallel actuation can result in deformation cross-talk, wherein actuation to deform one region of the reflective mirror surface 201 causes unintended deformations in another region of the reflective mirror surface 201.

Additionally, existing deformable mirrors may not be suitable for use in EUV lithographic apparatus LA, which must be robust to temperature changes to avoid unintended thermomechanical deformations due to the high thermal loads arising from the dissipation of the EUV radiation beam B. Due to the non-zero coefficient of thermal expansion (CTE) of one or more of the materials that generally are comprised in existing deformable mirrors, their use in EUV lithographic apparatus LA may be limited. Due to the varying CTE of the different materials such existing deformable mirrors are unsuitable for use in EUV lithographic apparatus LA.

The reflective mirror surface of existing deformable mirrors may be formed from fused quartz substrates which have a high stiffness, and therefore, very strong actuation forces are needed to deform the reflective mirror surface. Furthermore, such deformable mirrors may be constructed using glue. The use of glue may be problematic due to the relatively high CTE (in comparison to other components of the deformable mirrors) which could cause unacceptable drift.

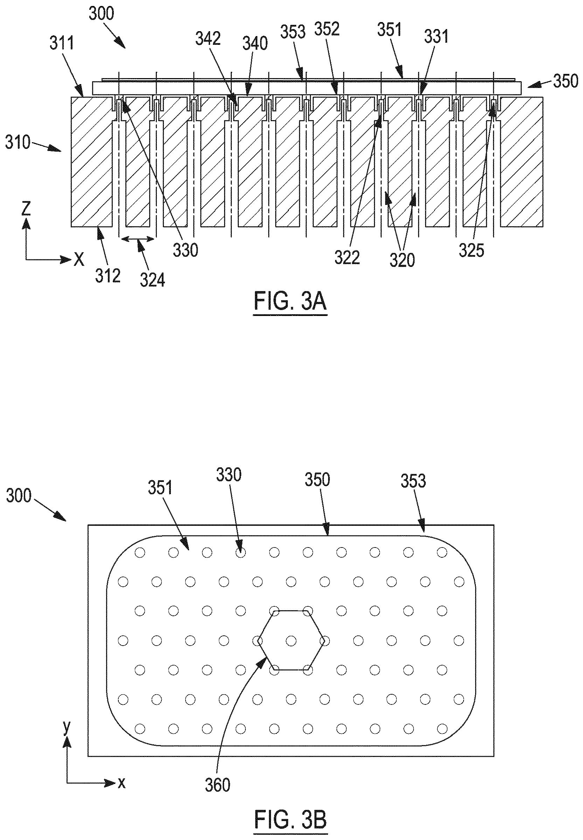

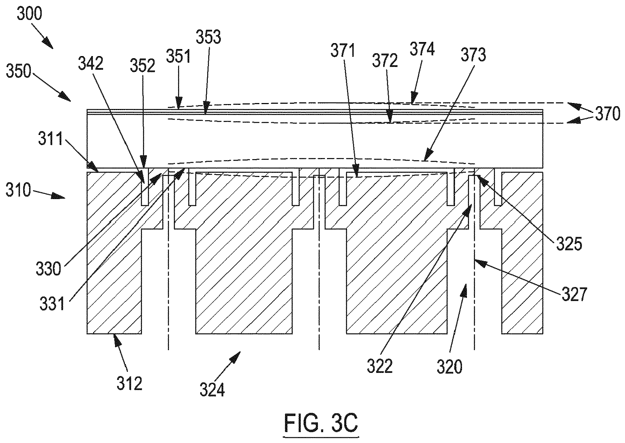

Figures 3A, 3B and 3C depict a deformable mirror system 300. The deformable mirror system 300 may be used in a lithographic apparatus LA of the type shown in Figure 1. The deformable mirror system 300 comprises a monolithic support structure 310. That is to say that the structure 310 is formed from a single piece of a homogeneous material without any adhesive, mechanical or other forms of fixing to join additional pieces of the same or another material. The support structure 310 is constructed in such a way that it is able to receive one or more actuators, which can be provided to deform a portion of the support structure 310 that is in contact with a mirror 350 and thereby deform the reflective mirror surface 351. It can be seen from figures 3A and 3C that the support structure 310 has a first side 311 and a second side 312 generally opposite the first side 311. The first side 311 of the structure 310 is configured to receive the mirror 350. The second side 312 is configured to receive the actuators.

As shown in figures 3A, 3B and 3C, the second side 312 of the support structure 310 that is configured to receive the actuators is provided with a plurality of cavities 320. Each one of the plurality of cavities 320 may be configured to receive an actuator. The shape of each one of the plurality of cavities 320 may be shaped to be complementary to the shape of the actuator it will receive. For example, the walls of one or more of the cavities 320 may define a right prism with substantially the same cross-sectional shape as the actuator which it is intended to receive. Each of the one or more of the cavities 320 may take any appropriate shape, such as a cone, a different prism, a frustum or a non-regular polyhedron.

The cavities 320 depicted in figures 3A and 3C are depicted as having a first wider portion adjacent to the second side 312 of the support structure 310, the first wider portion being in communication with a second narrower portion 322 adjacent to the first side 311 of the support structure 310. By providing a wider portion adjacent to the second side 312, installation of actuators within the cavities 320 is facilitated. For example, the wider portion may be wider than the actuators to be received within the cavities 320, while the narrower portion 322 may be shaped to provide an interference fit with a received actuator.

The cavities 320 may be distributed across the second surface 312 of the support structure 310 in any manner. For example, the plurality of cavities 320 may be arranged to form a regular arrangement, such as a hexagonal lattice structure 360 (shown in figure 3B), or any other regular 2-D lattice structure, across the second side 312. Alternatively, the plurality of cavities 320 may be arranged in different structure, for example, an irregular 2-D lattice structure to customize the deformable properties of the mirror.

As shown in figures 3A, 3B and 3C, the first side 311 of the support structure 310 may be provided with a plurality of pillars 330 that are configured to be in physical contact with a second side 352 (or underside, from the perspective of the direction of propagation of radiation incident on a reflective surface 351 of the mirror 350) of the mirror 350 when the mirror 350 is installed on the structure 310. In this way, when installed on the support structure 310, the mirror 350 rests atop the pillars 330. The top face 331 of each pillar 330 may be considered to be part of the first side 311 of the support structure 310. Each of the pillars 330 may extend, for example by 10-100 µm, beyond a plane that is otherwise defined by the first side 311 of the support structure 310. In this way, gaps 340 may be provided between the mirror 350 and the first side 311 of the support structure 310.

The pillars 330 may be provided in any way. For example, the pillars 330 may be provided by the creation of toroidal cavities 342 in the first side 311 of the support structure 310, with the centre of the toroid providing the pillar 330. For example, pillars 330 of circular cross-section may be provided by forming torus shaped cavities in the first side 311 of the support structure 310. Material may then be selectively removed from the first side 311 around the pillars 330, to cause the pillars 330 to extend beyond the plane defined by the first side 311 and to provide the gaps 340.

Each cavity 320 of the second side 312 of the support structure 310 may be positioned such that its central axis 327 is generally in-line with the central axis of each pillar 330. As shown in figures 3A and 3C, each cavity 320 may extend into a respective pillar 330, such that the pillars are hollow structures. Where the cavity comprises two portions as shown in Figure 3A, the second portion 322 of each cavity 320 may be partially, or entirely, contained within a respective pillar 330. In some arrangements, the cavity 320 may continue all the way through the structure 310.

In a neutral/resting position (i.e. the position and shape of the support structure when the actuators are not applying any force), the first side 311 of the support structure 310 may support the mirror 350 in a substantially planar configuration (as depicted in figures 3A and 3C). Alternatively, the first side 311 may support the plate 350 in a substantially convex, concave, parabolic or other shape. It will be appreciated that the shape of the side 352 of the mirror 350 that is in contact with the support structure 310 may be different to the side 353 of the mirror 350 on which the reflective surface 351 is provided. For example, the side 352 of the mirror 350 in contact with the side 311 of the support structure 310 may be planar, while the side 353 having the reflective surface 351 may be concave or convex (or vice versa). By applying force to the support structure 310 in the region of the first side 311, the first side 311 and therefore the mirror 350 may be deformed. A concave deformation of the support structure 310 and the mirror 350 is illustrated by dotted lines 371 and 372 (figure 3C), and a convex deformation of the support structure 310 and the mirror 350 is illustrated by dotted lines 373 and 374 (figure 3C). For example, the first side 311 of the support structure 310 may be substantially flat in its neutral position and may be deformed into a concave shape 371 when a force is applied and this may in turn deform the mirror 350 from a neutral, flat, position into a concave shape 372. As an alternative example, the first side 311 of the support structure 310 may be substantially flat in its neutral position and may be deformed into a convex shape 373 when a force is applied and this may in turn deform the mirror 350 from a neutral flat position into a convex shape 374. As a further example, the first side 311 of the support structure 310 may be substantially concave in its neutral position and may be deformed into a flat, convex or alternative concave shape when under an applied force. While these examples refer to the overall shape of the first side 311 of the support structure 310, it will be appreciated that the deformations may be small and only change the shape of the support structure 310 in the local region close to where the force is applied by a small amount, having substantially no effect on the remaining parts of the first side 311 of the support structure 310.

The mirror 350 may comprise a plate and a reflective mirror surface 351. The reflective mirror surface 351 may be formed on the plate in any way. For example, the reflective mirror surface 351 may be formed from a multi-layer coating on the plate. The reflective mirror surface 351 may be on a first side of the plate and the plate may contact the support structure 310 on a second side of the plate that is generally opposed to the first side of the plate.

The second side 352 of the mirror 350 may be fixed to the first side 311 of the support structure 310 using optical contacting, anodic bonding, soldering, diffusion bonding, chemical bonding, magnetism, or other mechanical fixtures. The first side 311 of the support structure 310 that is fixed to the second side 352 of the mirror 350 may only be fixed at the pillars 330.

Various dimensions of the exemplary arrangement shown in figures 3A-3C are now discussed, although it is to be understood that these are for illustration only and that the dimensions may vary depending upon the required application. In the example system 300 depicted in figures 3A, 3B and 3C, the reflective mirror surface 351 has an area of the order of 500 mm by 280 mm. The support structure 310 is provided with 73 cavities 320, arranged in a hexagonal pattern 360. The pitch 324 between a centre of each pillar 330 and a neighbouring pillar 330 is of the order of 40 mm. As shown in this example, the reflective mirror surface 351 may not extend across the whole of the surface of the first side 353 of the mirror 350. The mirror 350 may not extend across the whole of the surface of the first side 311 of the support structure 310. The depth (i.e. the extent in the depicted z direction) of the support structure 310 is approximately 100 mm and each one of the plurality of cavities 320 extends just under 100 mm into the second side 312 at its furthest point 325. The mirror 350 is approximately 10 mm deep. 73 pillars 330 are provided in the same position and arrangement as the cavities 320 and each one extends approximately 50 µm past the plane otherwise defined by the first side 311 of the structure 310.

Surface normal actuation is shown in figure 2B which depicts a mirror 210 with a reflective surface 211. The reflective surface 211 may be deformed by one or more actuators 212 which are fixed to the backside of the mirror at points 213 and fixed to a support 214. The actuators 212 allow actuation in a direction perpendicular to the mirror surface 211.

One way of deforming the support structure 310 is by the application of one or more forces from one or more actuators received in the cavities 320. Generally, actuators may be positioned such that they can apply forces in a direction substantially perpendicular to the first side 311 of the support structure 310 or the reflective mirror surface 351. By using the actuators in this way, the support structure 310 is provided with a method of deformation using surface normal actuation, as depicted in figure 2B, thereby mitigating the negative consequences of cross-talk that arise in surface parallel actuation. The forces applied to the support structure 310 by the actuators may be compression or tension forces or a mixture of both (e.g. one or more actuators may apply a compression force while one or more other actuators apply a tension force). It will be appreciated that the forces generated by the actuators may alternatively be referred to as pushing and pulling or extending and contracting. Alternatively, or additionally, actuators may be positioned such that they can apply forces in a direction parallel to the first side 311 of the support structure 310 or the reflective mirror surface 353. It will be appreciated that in the case of actuators applying surface parallel actuation, the arrangement of the cavities within the monolithic structure will be different to that depicted in figures 3A-3C. Alternatively, or additionally, rotary (or torsional) actuators may be provided to provide rotary motion or torque.

In this example, the support structure 310 and the mirror 350 may have a stiffness of, for example, approximately 3 N per nm. The reflective mirror surface 351 may therefore be displaced by 0.1-1 nm (in either direction perpendicular to the surfaces) using actuation forces of 0.3-3 N. An illustrative displacement range is shown schematically by dotted lines 370.

To allow the application of a tension force, each actuator may be fixed within a cavity 320 at more than one point. Alternatively, if only a compression force is required, each actuator may be fixed within a cavity 320 at a single point. The actuators may be fixed at any point within the cavity using optical contacting, anodic bonding, soldering, diffusion bonding, chemical adhesives or other fixing means. With reference to Figure 3C, for example, to enable both tension and compression, an actuator maybe fixed to a distal end of the cavity 320 (e.g. in the vicinity of the point 325) and at another point closer to the proximal end of the cavity (i.e. closer to the second side 312). It will be appreciated that to facilitate deformation forces only in the positive z-direction, the actuator need not be fixed to the cavity near the point 325. In an example in which the cavity extends all of the way through the support structure 310, the actuator may contact (or be fixed to) a point on the second side 352 of the mirror 350 instead of a point within the cavity near to the distal end of the cavity.

Each one of the plurality of actuators may be any type of actuator. For example, the actuators may be a pneumatic, hydrostatic, Lorentz, reluctance or thermal mechanical actuator. The properties of each type of actuator may make them particular suited for a particular use of the support structure 310.

For example, the support structure 310 may be provided with pneumatic actuators. Pneumatic actuators may be operated in a temperature insensitive manner by correcting the inputs for any pressure changes due to changes in temperature. Pneumatic actuators may also reduce the risk of contamination to other components in the event of a leakage. The pneumatic actuators may use nitrogen, argon or another compressed gas. The pressure volumes of pneumatic actuators may be kept small and close to the pressure control unit to allow higher frequency deformations.

As an alternative example, the support structure 310 may be provided with hydrostatic (or hydraulic) actuators. Hydrostatic actuators may also be operated in a temperature insensitive manner by correcting the inputs for any pressure changes due to changes in temperature. Hydrostatic actuators may also make use of a less compressible power transferring medium and allow for higher frequency deformations. The hydrostatic actuators may use water or another fluid. The pressure volumes of the hydrostatic actuators may be kept small and close to the pressure control unit to allow higher frequency deformations.

As a further alternative, the support may be provided with Lorentz actuators. Lorentz actuators may be open loop or closed loop.

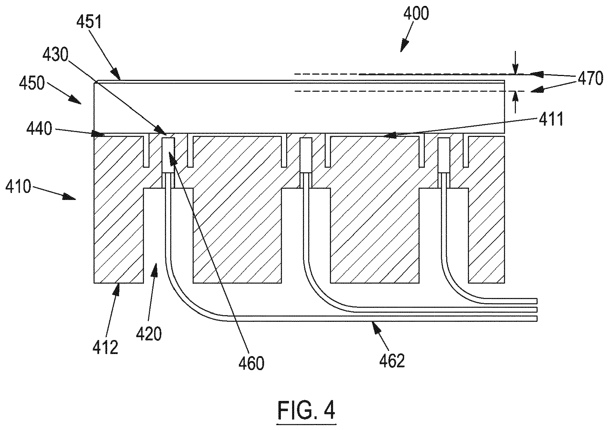

Figures 4 depicts a deformable mirror system 400, having substantially the same form as the example depicted in figures 3A, 3B and 3C. The deformable mirror system 400 comprises a monolithic support structure 410 with pillars 430 extending beyond a plane defined by a first side 411 of the support structure 410 and cavities 420 provided in a second side 412 of the support structure 410. A mirror 450 with a multi-layer coating that provides the reflective mirror surface 451 is supported on the monolithic support structure 410. The extension of the pillars beyond the plane defined by the first side 411 creates gaps 440 between the first side 411 and the underside of the mirror 450. The example in figure 4 is further provided with pneumatic or hydrostatic actuators 460 which provide means for deforming the reflective mirror surface 451. An illustrative displacement range of the reflective mirror surface 451 is shown schematically by dotted lines 470. In the example of figure 4, each actuator has an outer diameter of the order of 2 mm, which matches an inner diameter of each cavity 420. Each pillar 430 has an outer diameter of 8 mm. It will be appreciated that all dimensions are exemplary and that actual dimensions will vary depending upon the particular application.

In this example, the mirror 450 may have a pressure sensitivity of, for example, approximately 10⁻¹⁴ m per Pa. The internal pressure of each actuator 460 may be controlled with a resolution of 100 Pa allowing the actuator position to be controlled with a resolution of 10⁻¹² m (1 pm). The reflective mirror surface 451 may be locally deformed by up to around 10 nm in either direction perpendicular to its surface. Performance of the deformable mirror system 400 may be further improved by reducing the pressure volumes of the actuators and minimizing the length of the connection 462 between each actuator and its pressure control unit. Such improvements may allow actuator bandwidths of 100 Hz to be achieved.

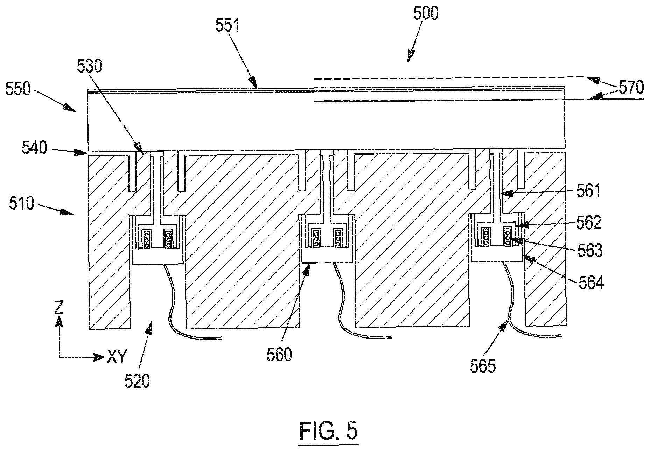

Figure 5 depicts an alternative example to the one depicted in figure 4 with a deformable mirror system 500 having generally the same arrangement as the deformable mirror systems 300 and 400. The deformable mirror system 500 includes a monolithic support structure 510 and pillars 530 on which rests a mirror 550. The pillars extend beyond the plane defined by a first side of the support structure 510 creating gaps 540 between the support structure 510 and the mirror 550. Cavities 520 are provided in a second side of the support structure 510. The diameter of the cavities and pillars is the same as those described above with reference to figure 4. The support structure 500 is provided with a number of Lorentz (or voice coil) actuators 560 disposed in respective ones of the cavities 520 which provide means for deforming the mirror surface 551. An illustrative displacement range of the reflective mirror surface 551 is shown schematically by dotted lines 5'70. Each Lorentz actuator 560 is provided with a coil unit 563 and magnet yoke 562 in a housing 564. The housing 564 may be constructed from ULE materials. Control signals are sent to each actuator 560 through a control line 565. In this example, each cavity 520 extends the whole way through the support structure 510, such that the Lorentz actuators 560 are provided with struts 561 allowing them to directly contact the second side of the mirror 550.

In the examples disclosed herein, the mirror 350, 450, 550 provides a reflective mirror surface by way of a multi-layer coating 351, 451, 551. The mirror 350, 450, 550 may not include a multi-layer coating and the reflective mirror surface 351, 451, 551 may be provided through other means. The plurality of coatings may be applied in an additional step in the construction process. The reflective mirror surface 351, 451, 551 may be achieved through alternative provisions.

The deformable mirror system 300, 400, 500 may be configured for use in DUV, EUV or any other lithographic apparatus LA. The support structure 310, 410, 510, the mirror 350, 450, 550, or other components may be constructed from ultra-low expansion (ULE) materials, for example, ULE glass from Corning Incorporated.

In an embodiment, a lithographic apparatus LA comprises one or more of the deformable mirror systems 300, 400, 500 described in the above examples. The lithographic apparatus LA may be configured for EUV or DUV lithography.

In another example described herein there is a method of constructing the deformable mirror support.

Selective laser etching may be used in the construction of the deformable mirror system 300, 400, 500. Advantageously, this allows for the deformable mirror system 300, 400, 500 to be constructed from a monolithic structure ensuring global stiffness and stability. Other methods, for example, CNC drilling or machining or 3D printing may be used.

Methods of fixing may be required to fix different components of the deformable mirror system 300, 400, 500 together. Example methods of fixing include optical contacting, anodic bonding, soldering, diffusion bonding, magnetism or chemical adhesion. For example, adhesive may be used fixing actuators 460, 560 in place within cavities 420, 520 or fixing the second side 352 of the mirror 350 to the first side 311 of the structure 310.

Reference is made herein to angles that are perpendicular, normal or parallel to various components, for example, the first side of the support structure 310, 410, 510 or the reflective mirror surface 351, 451, 551. Where these angles refer to an angle made between a first component (for example, an actuator 460, 560) and the second component (for example, the reflective mirror surface 351, 451, 551), it should be understood that this refers to the angle made between the main axis of the components (for example, the axis along which the actuator 460, 560 provides an actuator force) and an imaginary tangential plane that just touches the second component (for example, the plane defined by the reflective mirror surface 351, 451, 551) at the point closest to the first component, while no forces are being applied to the support structure 310, 410, 510. For example, in the example of a flat reflective mirror surface 351, 451, 551 there is a single imaginary tangential plane for all points on the reflective mirror surface 351, 451, 551. In the example of a curved mirror, such as a concave or convex mirror, there will be a different imaginary tangential plane for each point on the reflective mirror surface and the relevant imaginary tangential plane is the one that contacts the reflective mirror surface 351, 451, 551 at a point closest to the first object.

References made to angles should also be understood to include angles generally near to the angle referenced.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A deformable mirror system (300, 400, 500), comprising a monolithic support structure (310, 410, 510), comprising:
a first side (311) configured to receive a mirror (350, 450, 550); and
a second side (312) configured to receive a plurality of actuators (460, 560) such that the actuators are positioned to enable selective deformation of a reflective surface (351, 451, 551) of the mirror.

2. The deformable mirror system (300, 400, 500) of claim 1, wherein the support structure (310, 410, 510) comprises a plurality of cavities (320, 420, 520) which extend through the second side (312), each one of the plurality of cavities configured to receive at least one of the plurality of actuators (460, 560).

3. The deformable mirror system (300, 400, 500) of claim 2, wherein the plurality of cavities (320, 420, 520) is arranged to form a regular 2-D lattice structure across the second side (312) of the support structure (310, 410, 510).

4. The deformable mirror system (300, 400, 500) of any preceding claim, wherein the first side (311) of the support structure (310, 410, 510) comprises a plurality of pillars (330, 430, 530), wherein at least one of the plurality of pillars is configured to support the mirror (350, 450, 550).

5. The deformable mirror system (300, 400, 500) of claim 4, wherein the plurality of pillars (330, 430, 530) is arranged to form regular 2-D lattice structure across the first side (311).

6. The deformable mirror system of claims 4 or 5, wherein at least one of the plurality of pillars (330, 430, 530) is arranged co-axially (327) with at least a portion of at least one of the plurality of cavities (320, 420, 520).

7. The deformable mirror system (300, 400, 500) of any of the preceding claims, further comprising the mirror (350, 450, 550), the mirror comprising a plate having a reflective mirror surface (351, 451, 551), and wherein the plate is fixed to the first side (311) of the support structure (310, 410, 510).

8. The deformable mirror system (300, 400, 500) of any preceding claim, further comprising the plurality of actuators (460, 560).

9. The deformable mirror system (300, 400, 500) of claim 8, wherein one or more of the plurality of actuators (460, 560) is configured to apply compression or tension forces to an underside of the mirror (350, 450, 550).

10. The deformable mirror system (300, 400, 500) of claim 9 wherein a majority of the compression or tension forces from the plurality of actuators (460, 560) are applied in a direction generally perpendicular to the reflective mirror surface (351, 451, 551) of the mirror (350, 450, 550).

11. The deformable mirror system (300, 400, 500) of any preceding claim, wherein each one of the plurality of actuators (460, 560) is a pneumatic, hydrostatic, Lorentz, reluctance or thermal mechanical actuator.

12. A lithographic apparatus (LA) comprising one or more deformable mirror systems (300, 400, 500) of any preceding claim.

13. The lithographic apparatus (LA) of claim 12, wherein the lithographic apparatus is an EUV lithographic apparatus.
